# EUROPEAN PATENT APPLICATION

(11) **EP 4 686 911 A1**
(43) Date of publication of application: **04.02.2026**
(21) Application number: 25189651.0
(22) Date of filing: 15.07.2025
(51) Int. Cl.: G01C 19/5712, B81B 3/00, G01P 15/08

(54) **MICROELECTROMECHANICAL STRUCTURE WITH IMPROVED MECHANICAL ROBUSTNESS**

(30) Priority: 30.07.2024 IT 202400017707
(71) Applicant: STMicroelectronics International N.V., 1228 Plan-les-Ouates, Geneva (CH)
(72) Inventor: FEDELI, Patrick, 20030 SENAGO (MI) (IT); CARULLI, Paola, 20148 MILANO (IT); FALORNI, Luca Giuseppe, 20812 LIMBIATE (MB) (IT); MORELLI, Federico, 20148 MILANO (IT)
(74) Representative: Studio Torta S.p.A.

(57) **Abstract**

A microelectromechanical structure (10) is described, having a mobile mass (12) with a main extension in a horizontal plane (xy), defined by a first (x) and a second (y) horizontal axes, and having internally a window (14). The mobile mass is elastically coupled to a central anchoring structure (15), arranged centrally with respect to the window (14), by means of an elastic structure (16), so that it is able to perform a first rotation movement outside the horizontal plane and a second rotation movement in the horizontal plane. The elastic structure (16) has a first median or symmetry axis (Mx) parallel to the first horizontal axis (x) and a second median or symmetry axis (My) parallel to the second horizontal axis (y) and has a first and a second elastic elements (16a, 16b) arranged in a central position of the window (14), on opposite sides with respect to the first median or symmetry axis. The first and second elastic elements (16a, 16b) substantially have the shape of an "H" in the horizontal plane (xy), specularly with respect to the first median or symmetry axis (Mx) and face each other at a certain separation distance along the second horizontal axis (y).

## Description

### TECHNICAL FIELD

The present solution relates to a microelectromechanical structure with improved mechanical robustness.

### BACKGROUND

As is known, microelectromechanical structures (of a MEMS - MicroElectroMechanical System - type), made with semiconductor technology, are used to provide several electronic devices, for example inertial sensing devices, such as gyroscopes or accelerometers, resonators, actuators or the like.

For instance, microelectromechanical structures are known having a mobile mass (for example, a sensing mass) configured to perform a first rotation movement in a plane of main extension and also a second rotation movement outside the same plane.

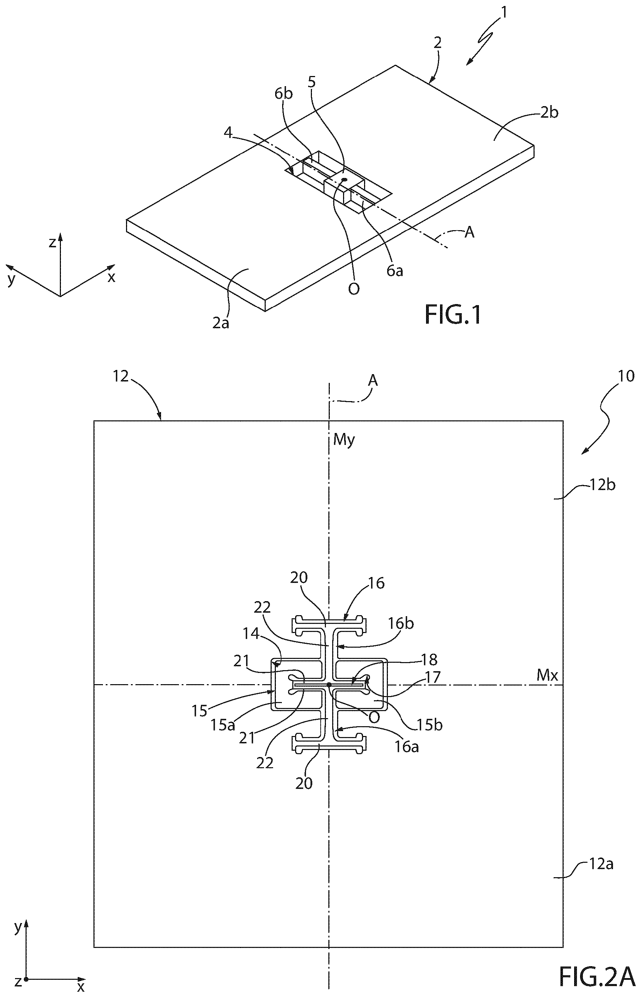

Figure 1 shows in a schematic manner a microelectromechanical structure of this type, generally indicated by 1, for example designed to provide an accelerometer or a gyroscope (having one or more sensing axes).

The microelectromechanical structure 1 comprises a mobile mass 2 (in particular, a sensing mass) having a main extension in a horizontal plane xy, defined by a first and a second horizontal axes x, y and having a smaller extension (substantially negligible compared to the aforementioned main extension) along a vertical axis z, orthogonal to the horizontal plane xy.

In the example, the mobile mass 2 has, in the aforementioned horizontal plane xy, a generically rectangular shape, extending along the first horizontal axis x and along the second horizontal axis y, perpendicular to the first axis, with dimensions due to design specifications and constraints.

In a manner not illustrated herein, the mobile mass 2 is arranged suspended above a substrate of the microelectromechanical structure 1, having an upper surface (facing the mobile mass 2) whereon fixed sensing electrodes (capacitively coupled to the same mobile mass 2) are typically formed.

The mobile mass 2 internally defines a window 4 that divides it into a first and a second portions 2a, 2b, which may have a mass distribution that is symmetrical (such as in the case illustrated) or asymmetrical (for example, with the first portion 2a having an extension along the first horizontal axis x greater than the corresponding extension of the second portion 2b).

The mobile mass 2 is elastically coupled to a central anchor 5 by means of a first and a second elastic elements 6a, 6b; this central anchor 5 has for example a pillar shape, is arranged centrally with respect to the window 4 and is coupled at the bottom to the substrate in an integral manner (in a manner not illustrated here).

The first and second elastic elements 6a, 6b are of the torsional type, have a linear extension along the second horizontal axis y of the horizontal plane xy and are aligned along the same horizontal axis y defining a rotation axis A for the mobile mass 2 (parallel to the second horizontal axis y).

In particular, the mobile mass 2 is able to move (for example dragged by a driving mass, here not illustrated, or due to inertial effect in the presence of an acceleration or another external stimulus acting along the vertical axis z), with a first rotation movement around the aforementioned rotation axis A, in particular a tilting or teeter-totter movement with central fulcrum at the central anchor 5.

In a manner not illustrated, the aforementioned fixed sensing electrodes typically comprise a first and a second fixed electrodes, arranged below the inertial mass 2, on opposite sides with respect to the window 4 (a first fixed electrode arranged below the first portion 2a and a second fixed electrode arranged below the second portion 2b of the inertial mass 2, forming a pair of sensing capacitors).

The aforementioned rotation of the inertial mass 2 around the rotation axis A therefore determines a movement of the inertial mass 2 towards/away form a first fixed electrode and a corresponding movement of the same inertial mass 2 away from/towards a second fixed electrode, thereby causing a differential capacitive variation of the aforementioned sensing capacitors, indicative of a quantity to be sensed (for example, an angular velocity or an acceleration or another external stimulus).

The mobile mass 2 is also configured to move (for example dragged by a driving mass, here not illustrated) with a second rotation movement in the horizontal plane xy, in particular around an axis parallel to the vertical axis z and passing through the aforementioned central anchor 5 (for example, at a corresponding geometric center O).

In the microelectromechanical structure 1, the aforementioned first and second elastic elements 6a, 6b are therefore required to be suitably configured and sized in order to allow both rotation movements (outside the horizontal plane xy and in the horizontal plane xy) of the mobile mass 2.

A possible issue of a microelectromechanical structure of this type is due to robustness against shocks, i.e. against impulsive impacts or vibrations, which may in particular occur along the direction of the vertical axis z, for example due to falls or impacts.

In particular, the shocks to which the microelectromechanical structure may be subject may also be very high, for example up to 10³-10⁵ g of acceleration. Such shocks may produce a significant deformation of the elastic elements, with resulting high stresses, which may also be higher than the mechanical breaking limit of the material of the microelectromechanical structure (typically, silicon) and possibly cause damage to the same microelectromechanical structure.

In particular, in the case of the microelectromechanical structure 1 of Figure 1, a maximum stress due to the aforementioned shocks typically occurs at the coupling zone of the first and the second elastic elements 6a, 6b to the central anchor 5.

A known solution to avoid possible breakdowns envisages inserting stoppers into the microelectromechanical structure in suitable positions, at a given distance from the mobile mass, to limit the range of displacement in the event of a shock.

However, the introduction of such stoppers may complicate the design of the microelectromechanical structure; furthermore, the distance between the same stoppers and the mobile mass is typically imposed by the manufacturing process and therefore cannot be adjustable as desired.

Another solution to limit the issues associated with shocks envisages suitably designing the elastic elements of the microelectromechanical structure. The design of the elastic elements in fact strongly influences the stress level (i.e., the force per area unit that the material experiences when subject to shock) and therefore the intrinsic robustness and functionality of the entire microelectromechanical structure.

The present Applicant has however found that the layouts typically used for manufacturing such elastic elements allow obtaining suitable robustness solely for mobile masses with a low inertia (for example for so-called "consumer" products or applications).

At least for certain applications, a need to provide solutions that allow increasing the mechanical robustness of the microelectromechanical structures against shocks is therefore certainly felt.

### SUMMARY

The present solution generally aims to overcome the limitations of known-type systems and to provide an answer to the aforementioned need.

According to the present solution, a microelectromechanical structure is therefore provided, as defined in the attached claims.

### BRIEF DESCRIPTION OF THE FIGURES

For a better understanding of the present invention, a preferred embodiment thereof is now described, purely by way of non-limiting example and with reference to the attached drawings, wherein:
- Figure 1 shows a schematic perspective plan view of a microelectromechanical structure of a known type;
- Figure 2A shows a schematic plan view of a microelectromechanical structure provided according to an embodiment of the present solution;
- Figure 2B shows an enlargement of a portion of the microelectromechanical structure of Figure 2A, relating to an elastic and anchoring structure;
- Figure 3 shows the result of a simulation, with respect to the portion of interest of the elastic and anchoring structure, where expected stress generated by a mechanical strain in the event of an impact are highlighted;
- Figures 4A and 4B show plots relating to the trend of the stress acting on the microelectromechanical structure as a function of time, at the points of interest, in response to an initial impulsive shock.

### DESCRIPTION OF EMBODIMENTS

As will be described below, one aspect of the present solution envisages providing an optimized elastic structure for the elastic coupling of at least one mobile mass of a microelectromechanical structure to a corresponding anchor, in order to reduce stresses that may occur due to a shock (for example, due to a fall, an impact or a similar mechanical strain), in particular in the direction of a vertical axis, orthogonal to a main extension plane of the same microelectromechanical structure.

The aforementioned elastic structure is advantageously designed so as not to significantly impact the operating modes of the microelectromechanical structure, in particular not to alter its corresponding main operating frequencies (for example, one or more driving or sensing frequencies).

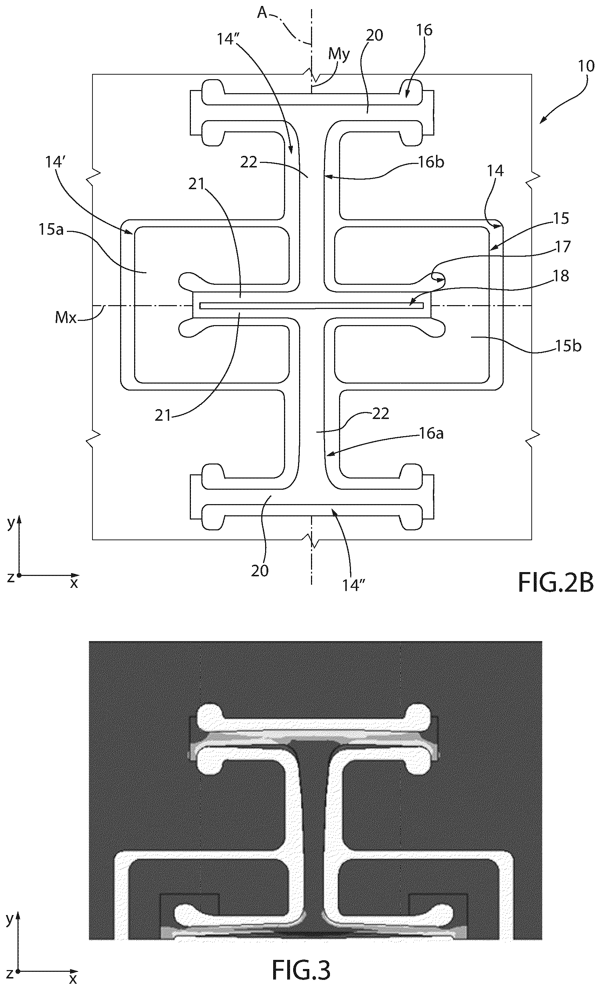

Figures 2A and 2B show a microelectromechanical structure 10 according to one embodiment of the present solution, for example designed to be part of a gyroscope or an accelerometer or in general of an inertial sensor (without however the present discussion having to be limited to such exemplary applications).

In a manner substantially similar to what has been previously discussed, the microelectromechanical structure 10, made using manufacturing processes (of a known type, not described in detail herein) of semiconductor, in particular silicon, material comprises a mobile mass 12 (in particular a sensing mass) having a main extension in a horizontal plane xy, defined by a first and a second horizontal axes x, y and in a manner not illustrated herein having a smaller extension (substantially negligible with respect to the aforementioned main extension) along a vertical axis z, orthogonal to the horizontal plane xy. In the example, the mobile mass 12 has a generally rectangular shape, elongated in this case along the second horizontal axis y.

The mobile mass 12 also defines internally a window 14, which divides it into a first and a second portions 12a, 12b, and is elastically coupled to a central anchoring structure 15, arranged centrally with respect to the window 14, by means of an elastic structure 16.

As will be described in detail, this elastic structure 16 generally defines a rotation axis A, in this case parallel to the second horizontal axis y, for the mobile mass 12; the same mobile mass 12 may move (for example dragged by a driving mass, here not illustrated, or due to inertial effect in the presence of an external acceleration or another stimulus quantity acting along the vertical axis z), with a first rotation movement, in particular a tilting or teeter-totter movement with central fulcrum, around the aforementioned rotation axis A.

The same mobile mass 12 may also move (for example dragged by a driving mass, here not illustrated) with a second rotation movement in the horizontal plane xy, in particular around an axis parallel to the vertical axis z and passing through a geometric center O of the aforementioned central anchoring structure 15.

The elastic structure 16 has a first median or symmetry axis Mx parallel to the aforementioned first horizontal axis x and a second median or symmetry axis My parallel to the aforementioned second horizontal axis y (in this embodiment, the microelectromechanical structure 10 is entirely symmetrical with respect to said first and second median or symmetry axes Mx, My). The aforementioned geometric center O is the intersection between the same first and second median or symmetry axes Mx, My.

The central anchoring structure 15 comprises a first and a second anchors 15a, 15b arranged in a central position on opposite sides and specularly with respect to the rotation axis A (or to the second median or symmetry axis My), facing each other at a certain separation distance (considered along the first horizontal axis x).

In particular, in the embodiment illustrated in the aforementioned Figures 2A and 2B, the first anchor 15a has a "C" shape and the second anchor 15b has a corresponding "inverted-C" shape, specularly to the aforementioned first anchor 15a with respect to the rotation axis A (and to the second median or symmetry axis My). The first and second anchors 15a, 15b define as a whole a central recess 17, arranged at the aforementioned first median or symmetry axis Mx.

The elastic structure 16 comprises a first and a second elastic elements 16a, 16b arranged in a central position, on opposite sides and specularly with respect to the first median or symmetry axis Mx, facing each other at a certain separation distance (considered along the second horizontal axis y).

In detail, in the embodiment illustrated in the aforementioned Figures 2A and 2B, the first and second elastic elements 16a, 16b have the shape of an "H", specularly with respect to the aforementioned first median or symmetry axis Mx and are separated along the second horizontal axis y by a slot or gap 18, having a substantially rectangular shape in the horizontal plane xy, elongated along the first horizontal axis x and very thin (i.e. having a much smaller extension along the second horizontal axis y).

In general, the thickness of such gap 18 (considered along the second horizontal axis y) may be sized as a minimum value allowed by the technological manufacturing process, for example by corresponding masking and etching steps, or to a slightly higher value (for example in the event where it is required to ensure a driving movement around the z axis without generating mechanical interferences in corresponding portions of the elastic elements 21). In general, the aforementioned sizing of the gap 18 allows the stiffness of the rotation driving movement around the z axis not to be excessively altered.

In greater detail (and as illustrated in an enlarged manner in the aforementioned Figure 2B), each of the first and second elastic elements 16a, 16b comprises a first and a second lateral portions 20, 21, having a substantially rectangular shape in the horizontal plane xy, with an extension parallel to the first horizontal axis x, and a central portion 22 which centrally couples the first and second lateral portions 20, 21, having a substantially rectangular shape in the horizontal plane xy, with an extension parallel to the second horizontal axis y.

In particular, the central portions 22 of the first and second elastic elements 16a, 16b are aligned with each other and jointly define the aforementioned rotation axis A for the mobile mass 12.

Furthermore, the first lateral portions 20 of the first and second elastic elements 16a, 16b have respective ends coupled to the mobile mass 12 on opposite sides with respect to the rotation axis A, respectively to the first and to the second portions 12a, 12b of the same mobile mass 12.

The second lateral portions 21 of the first and second elastic elements 16a, 16b have respective ends coupled to the central anchoring structure 15, in particular to the first and second anchors 15a, 15b, at the central recess 17.

The first and second lateral portions 20, 21 may have, as in the embodiment illustrated in Figures 2A, 2B, substantially a corresponding extension along the first horizontal axis x; alternatively, the same first and second lateral portions 20, 21 may have different extensions along the first horizontal axis x.

In a possible embodiment (illustrated in Figures 2A, 2B), the central portions 22 of the first and second elastic elements 16a, 16b have a thickness, in this case considered along the first horizontal axis x, greater than a respective thickness of both the first and the second lateral portions 20, 21 (in this case considered along the second horizontal axis y). Furthermore, the second lateral portion 21 of the first and second elastic elements 16a, 16b has a thickness smaller than a respective thickness of the first lateral portion 20 (the second lateral portion 21 is therefore thinner than the first lateral portion 20 and also than the central portion 22).

In the embodiment illustrated in the same Figures 2A and 2B, the aforementioned window 14 has a shape that follows and replicates the shape of the elastic structure 16 and the anchoring structure 15, thus having a substantially rectangular central opening portion 14' with extension along the first horizontal axis x and lateral opening portions 14" having a "T" shape.

During operation, the mobile mass 12 is able to rotate outside the horizontal plane xy around the rotation axis A, mainly due to the torsion of the central portions 22 of the first and second elastic elements 16a, 16b (the first and the second lateral portions 20, 21 of the same first and second elastic elements 16a, 16b are rigid to bending, outside the same horizontal plane xy, during rotation around the rotation axis A).

Furthermore, the same mobile mass 12 is able to rotate in the horizontal plane xy, around an axis parallel to the vertical axis z passing through the center O, mainly due to the bending of the central portions 22 of the first and second elastic elements 16a, 16b in the same horizontal plane xy (the first and second lateral portions 20, 21 of the same elastic elements 16a, 16b are rigid to bending in the horizontal plane xy).

In particular, the configuration of the elastic elements 16a, 16b is such that the corresponding second lateral portions 21 do not contribute substantially to defining the operating frequencies and modes for the aforementioned first and second rotation movements.

The second lateral portions 21, separated by the gap 18 (which decouples the same second lateral portions 21 in the direction of the second horizontal axis y), conversely allow reducing the effects of shocks, in particular shocks acting along the vertical axis z.

In this regard, Figure 3 shows the manner in which stresses resulting from a shock along the vertical axis z discharge uniformly along the entire extension of the first and second lateral portions 20, 21, without creating dangerous stress concentrations (which might cause to exceed structural limits of the material of the elastic elements, typically silicon).

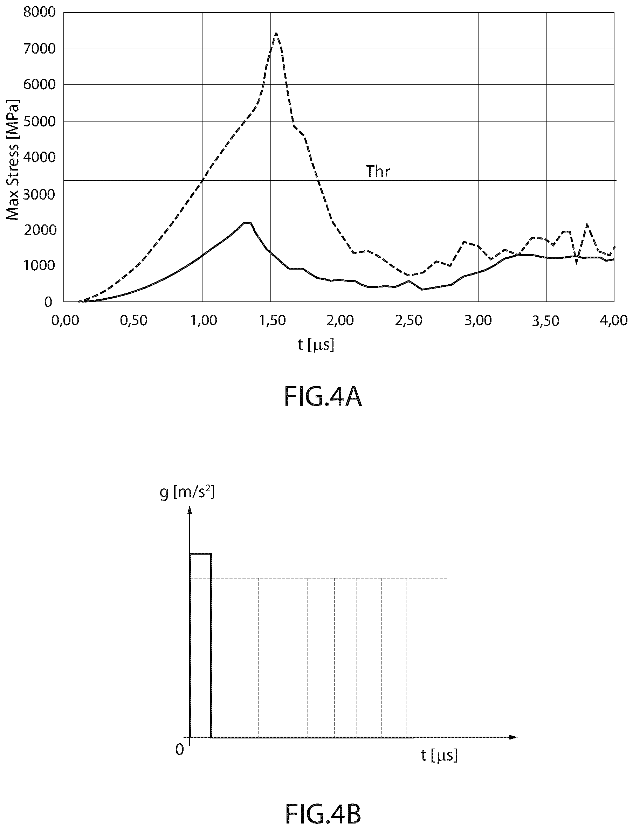

Furthermore, Figure 4A shows, in solid line, the trend of a maximum stress value ('Max stress') acting on the microelectromechanical structure 10 (in particular on the corresponding elastic elements) as a function of time, in response to an impulsive shock at an initial time, as shown in Figure 4B.

In particular, in Figure 4A this trend is compared with a corresponding trend of the stress that may occur in a known microelectromechanical structure (for example of the type described with reference to Figure 1), which is depicted in a dashed line.

It is apparent that the described solution allows to significantly reduce the maximum peak of the achievable stress, which is significantly lower than a material breakdown threshold Thr; conversely, in the known solution, a same shock may instead entail the exceeding of the same material breakdown threshold Thr.

The advantages of the proposed solution are clear from the preceding description.

In any case, it is underlined that the solution described allows to significantly reduce the stresses that may occur due to shocks, in particular acting in the direction of the vertical axis, without at the same time affecting the operating conditions of the microelectromechanical structure, in particular without altering the corresponding modes or the corresponding operating frequencies.

In fact, as previously indicated, the elastic elements that couple the mobile mass to the anchor integral to the substrate are configured and sized to increase the robustness, without however modifying the operating modes.

Furthermore, the manufacturing of the described structure does not require a substantial modification to the manufacturing process, in particular without requiring additional processing steps or different treatments.

Finally, it is clear that modifications and variations may be made to what has been described and illustrated herein without thereby departing from the scope of the present invention, as defined in the attached claims.

In particular, it is underlined that the described solution may find advantageous application regardless of the actual implementation of the microelectromechanical structure or the electronic device of which the same microelectromechanical structure is part (for example a sensor device, such as an accelerometer or a gyroscope, an actuator or the like).

In particular, it is underlined that the microelectromechanical structure may for example include a greater number of mobile masses, each or only some of which being able to be coupled to a corresponding anchoring structure by means of an elastic coupling structure similar to that previously described in order to reduce mechanical stresses.

Furthermore, the microelectromechanical structure may comprise one or more driving masses suitably configured and coupled to the mobile sensing masses to cause their movement (for example, according to the first and/or second rotation movement previously described).

For example, the microelectromechanical structure might be part of a MEMS gyroscope, as described in the European patent application 24177019.7 filed on 21/05/2024.

In such a MEMS gyroscope, of the triaxial type, two mobile masses arranged centrally to the microelectromechanical structure (able to perform the aforementioned first and second rotation movements, outside the horizontal plane and in the horizontal plane) may advantageously be elastically coupled to a respective anchor through an elastic coupling solution similar to that previously described, in order to reduce the stress in the event of shock.

## Claims

1. A microelectromechanical structure (10), comprising a mobile mass (12) having a main extension in a horizontal plane (xy), defined by a first (x) and a second (y) horizontal axes, and having internally a window (14), said mobile mass (12) being elastically coupled to a central anchoring structure (15), arranged centrally with respect to the window (14), by means of an elastic structure (16), configured so that said mobile mass (12) is able to perform a first rotation movement outside said horizontal plane (xy) and a second rotation movement in said horizontal plane (xy),
wherein said elastic structure (16) has a first median or symmetry axis (Mx) parallel to said first horizontal axis (x) and a second median or symmetry axis (My) parallel to said second horizontal axis (y) and comprises a first and a second elastic element (16a, 16b) arranged centrally to said window (14), on opposite sides with respect to the first median or symmetry axis (Mx),
**characterized by** said first and second elastic elements (16a, 16b) having substantially the shape of an "H" in the horizontal plane (xy), specularly with respect to said first median or symmetry axis (Mx) and facing each other at a certain separation distance along the second horizontal axis (y).

2. The structure according to claim 1, wherein said first and second elastic elements (16a, 16b) are separated along the second horizontal axis (y) by a gap (18), having a substantially rectangular shape in the horizontal plane (xy).

3. The structure according to claim 2, wherein said gap (18) is elongated along the first horizontal axis (x) and thin, having a greater extension along said first horizontal axis (x) and a smaller extension along the second horizontal axis (y).

4. The structure according to any of the preceding claims, wherein each of said first and second elastic elements (16a, 16b) comprises a first and a second lateral portions (20, 21), having a substantially rectangular shape in the horizontal plane (xy), with an extension parallel to the first horizontal axis (x), and a central portion (22) which centrally couples the first and second lateral portions (20, 21), having a substantially rectangular shape in the horizontal plane (xy), with an extension parallel to the second horizontal axis (y).

5. The structure according to claim 4, wherein the central portions (22) of the first and second elastic elements (16a, 16b) are aligned with each other and jointly define a rotation axis (A) for said first rotation movement of the mobile mass (12) outside the horizontal plane (xy).

6. The structure according to claim 5, wherein said first lateral portions (20) of the first and second elastic elements (16a, 16b) have respective ends coupled to the mobile mass (12) on opposite sides with respect to the rotation axis (A); and the second lateral portions (21) of the first and second elastic elements (16a, 16b) have respective ends coupled to the central anchoring structure (15).

7. The structure according to claim 5 or 6, wherein said central anchoring structure (15) comprises a first and a second anchors (15a, 15b) arranged in a central position on opposite sides and specularly with respect to the rotation axis (A), facing each other at a certain separation distance along the first horizontal axis (x).

8. The structure according to claim 7, wherein said first anchor (15a) has the shape of a "C" and the second anchor (15b) has a corresponding shape of an "inverted-C", specularly to the first anchor (15a) with respect to the rotation axis (A); and wherein said first and second anchors (15a, 15b) define as a whole a central recess (17).

9. The structure according to claim 8, wherein the second lateral portions (21) of the first and second elastic elements (16a, 16b) are arranged in said central recess (17) and have respective ends coupled to the first and respectively the second anchor (15a, 15b) of the central anchoring structure (15), at the central recess (17).

10. The structure according to any of claims 5-9, wherein said mobile mass (12) is configured to rotate with a first rotation movement outside the horizontal plane (xy) around the rotation axis (A), mainly due to torsion of the central portions (22) of said first and second elastic elements (16a, 16b); and to rotate with a second rotation movement in the horizontal plane (xy), around an axis parallel to a vertical axis (z), orthogonal to said horizontal plane (xy), mainly due to bending of the central portions (22) of said first and second elastic elements (16a, 16b) in the horizontal plane (xy).

11. The structure according to claim 10, wherein the configuration of said first and second elastic elements (16a, 16b) is such that the corresponding second lateral portions (21) do not contribute substantially to defining operating frequencies and modes for said first and second rotation movements.

12. The structure according to claim 11, wherein said gap (18) is configured to decouple said second lateral portions (21) in the direction of the second horizontal axis (y).

13. The structure according to any of the preceding claims, wherein said elastic structure (16) is configured to reduce effects of shocks acting along a vertical axis (z), orthogonal to said horizontal plane (xy), on said microelectromechanical structure (10).

14. The structure according to any of the preceding claims, defining a sensing structure of a gyroscope or a MEMS accelerometer.

15. A gyroscope or a MEMS accelerometer, comprising a structure according to any of the preceding claims.
